# EUROPEAN PATENT APPLICATION

(11) **EP 4 811 962 A1**
(43) Date of publication of application: **23.09.2026**
(21) Application number: 26162604.8
(22) Date of filing: 05.03.2026
(51) Int. Cl.: H10D 86/40, H10B 10/00, H10D 30/67, H10D 62/80, H10D 88/00

(54) **INVERTER INCLUDING OXIDE SEMICONDUCTOR, MEMORY DEVICE INCLUDING INVERTER, AND ELECTRONIC APPARATUS INCLUDING MEMORY DEVICE**

(30) Priority: 21.03.2025 KR 20250036624; 19.01.2026 KR 20260010287
(71) Applicant: Samsung Electronics Co., Ltd., Suwon-si, Gyeonggi-do 16677 (KR)
(72) Inventor: JANG, Younjin, 16678 Suwon-si (KR); CHOI, Minwoo, 16678 Suwon-si (KR); YANG, Kiyeon, 16678 Suwon-si (KR); Sung, Hajun, 16678 Suwon-si (KR); PARK, Yongyoung, 16678 Suwon-si (KR)
(74) Representative: Elkington and Fife LLP

(57) **Abstract**

An inverter includes a first field-effect transistor including a first channel layer, a first source/drain electrode and a second source/drain electrode disposed on opposite sides of the first channel layer, a first gate electrode facing the first channel layer, and a first gate insulating layer between the first channel layer and the first gate electrode, and a second field-effect transistor including a second channel layer, a third source/drain electrode and a fourth source/drain electrode disposed on opposite sides of the second channel layer, a second gate electrode facing the second channel layer, and a second gate insulating layer between the second channel layer and the second gate electrode. The first channel layer includes a p-type oxide semiconductor based on tellurium oxide, and the second channel layer includes an n-type oxide semiconductor based on indium oxide.

## Description

### FIELD OF THE INVENTION

Example embodiments of the disclosure relate to inverters including an oxide semiconductor, memory devices including the inverter, and/or electronic apparatuses including the memory device, and more particularly, to inverters including an n-type oxide semiconductor and a p-type oxide semiconductor, memory devices including the inverter, and/or electronic apparatuses including the memory device.

### BACKGROUND OF THE INVENTION

Oxide semiconductor transistors that use metal oxides as semiconductor channel layers may have various advantages, including transparency, relatively low-temperature processability, relatively high electron field-effect mobility, or relatively low leakage current. However, in the case of general oxide semiconductors, the valence band maximum (VBM) is composed of the 2p orbitals of oxygen ions and is located very deep from a vacuum level due to electronic structure characteristics, and thus, the hole field-effect mobility may be relatively low. In addition, p-type doping may be difficult in general oxide semiconductors. Due to this, the application of oxide semiconductor transistors may be limited in devices, such as static random-access memory (SRAM), which use relatively high-performance p-type semiconductor materials.

### SUMMARY OF THE INVENTION

Some example embodiments provide inverters including an n-type oxide semiconductor and a p-type oxide semiconductor.

In addition, some example embodiments provide memory devices including an n-type oxide semiconductor and a p-type oxide semiconductor.

Furthermore, some example embodiments provide electronic apparatuses including the memory device.

Additional aspects will be set forth in part in the description which follows and, in part, will be apparent from the description, or may be learned by practice of the presented example embodiments of the disclosure.

According to an example embodiment of the disclosure, an inverter includes a first field-effect transistor including a first channel layer, a first source/drain electrode and a second source/drain electrode spaced apart from each other on opposite sides of the first channel layer, a first gate electrode facing the first channel layer, and a first gate insulating layer between the first channel layer and the first gate electrode, and a second field-effect transistor including a second channel layer, a third source/drain electrode and a fourth source/drain electrode spaced apart from each other on opposite sides of the second channel layer, a second gate electrode facing the second channel layer, and a second gate insulating layer between the second channel layer and the second gate electrode, wherein the second source/drain electrode and the third source/drain electrode are electrically connected to each other, the first channel layer includes a p-type oxide semiconductor based on tellurium oxide, and the second channel layer includes an n-type oxide semiconductor based on indium oxide.

Proposed embodiments concern a complementary inverter architecture in which both pull-up and pull-down transistors utilise oxide semiconductor channel layers, specifically a p-type oxide based on tellurium oxide and an n-type oxide based on indium oxide. A proposed concept resides in selecting and engineering a tellurium-oxide-based p-type semiconductor (optionally doped or oxygen-deficient) whose hole mobility and on-current characteristics are comparable to those of indium-oxide-based n-type devices, thereby enabling a high-performance, fully oxide-based CMOS inverter suitable for memory integration.

The p-type channel layer may be defined either as TeOx doped with Se, Ge or S (e.g. TeaXbO with Te ≥ 70 at% of the cation fraction) or as indium tellurium oxide (InaTebOc) with Te-rich composition (b > 0.5) and sub-stoichiometric oxygen content. It may be understood that controlled oxygen vacancy concentrations (e.g. 5-80%) induce a shallow tellurium-related state near the valence band maximum, conferring stable p-type characteristics and enhanced hole mobility. This contrasts with conventional oxide semiconductors, whose deep valence band structure inhibits effective p-type behaviour. The n-type device may employ indium oxide, optionally doped (e.g. InaGabZncO with balanced cation ratios), providing established electron transport performance.

Electrical data demonstrates comparable mobility and current drive between the p- and n-type devices at matched geometries, addressing the conventional asymmetry that limits oxide-based CMOS implementation.

Structurally, embodiments may provide both planar and vertically stacked transistor configurations, including embodiments with separate gate stacks and embodiments with a single common gate electrode and gate dielectric shared between the p- and n-type devices. The stacked variants may enable vertical integration and reduced footprint, while specific electrode overlap arrangements may ensure electrical connection between the pull-up and pull-down devices without complex interconnect schemes. Common-gate embodiments may be of particular interest for density optimization and potential self-aligned processing.

Principal technical effects provided by embodiments may include: (i) improved inverter gain due to balanced carrier mobility; (ii) reduced leakage current inherent to oxide semiconductors; and (iii) enhanced integration density through stacked device architectures. These effects translate directly into improved SRAM cell performance, including reduced read noise and lower standby power. The memory architecture integrates the disclosed inverter pair into a conventional six-transistor SRAM cell, and further into cache memory within a CPU environment, demonstrating system-level applicability.

From a manufacturing perspective, the use of oxide semiconductors supports low-temperature processing and compatibility with transparent or thin-film electronics platforms, while the option of vertically stacked CMOS structures offers area reduction without requiring heterogeneous material systems (e.g. silicon plus III-V). A contribution provided by the proposed concept(s) therefore lies not merely in material selection, but in the recognition that oxygen-deficient Te-based oxides can provide sufficiently robust p-type performance to enable practical, balanced oxide CMOS inverters and memory cells.

For example, the p-type oxide semiconductor may include tellurium oxide doped with at least one element selected from selenium (Se), germanium (Ge), or sulfur (S).

For example, the p-type oxide semiconductor may include TeₐX_{b}O, where X may include at least one of selenium (Se), germanium (Ge), or sulfur (S), a ≥ 0.7, and b ≤ 0.3.

For example, the p-type oxide semiconductor may include InₐTe_{b}O_{c}, where a + b = 1, a ≤ 0.5, and b ≥ 0.5.

For example, c in InₐTe_{b}O_{c} may be less than a stoichiometric value.

For example, an oxygen vacancy concentration in InₐTe_{b}O_{c} may be about 5 % to about 80 %.

For example, the n-type oxide semiconductor may include indium oxide doped with at least one element selected from gallium (Ga), zinc (Zn), tin (Sn), or tungsten (W).

For example, the n-type oxide semiconductor may include InₐGa_{b}Zn_{c}O, where a = b = c.

In an embodiment, the inverter may further include a substrate, wherein the first channel layer, the first source/drain electrode, and the second source/drain electrode may be on the substrate, the first gate insulating layer may be on the first channel layer, and the first gate electrode may be on the first gate insulating layer.

The second gate electrode may be on the substrate, the second gate insulating layer may be on the substrate and cover the second gate electrode, and the second channel layer, the third source/drain electrode, and the fourth source/drain electrode may be on the second gate insulating layer.

An upper surface of the second source/drain electrode may include an exposed upper surface of the second source/drain electrode that is partially exposed between the first gate insulating layer and the second gate insulating layer, and the third source/drain electrode may extend over the exposed upper surface of the second source/drain electrode.

In an example embodiment, the inverter may further include a substrate, wherein the first gate electrode may be on the substrate, the first gate insulating layer may be on the substrate and cover the first gate electrode, and the first channel layer, the first source/drain electrode, and the second source/drain electrode may be on the first gate insulating layer.

The second channel layer, the third source/drain electrode, and the fourth source/drain electrode may be on the substrate, the second gate insulating layer may be on the second channel layer, and the second gate electrode may be on the second gate insulating layer.

An upper surface of the third source/drain electrode may include an exposed upper surface of the third source/drain electrode that is partially exposed between the first gate insulating layer and the second gate insulating layer, and the second source/drain electrode may extend over the exposed upper surface of the third source/drain electrode.

The first gate insulating layer and the second gate insulating layer may constitute a single common gate insulating layer, and the first gate electrode and the second gate electrode may constitute a single common gate electrode.

In an example embodiment, the inverter may further include a substrate, wherein the first channel layer, the first source/drain electrode, and the second source/drain electrode may be on the substrate, the single common gate insulating layer may be on the first channel layer, the single common gate electrode may be buried in the single common gate insulating layer, the second channel layer, the third source/drain electrode, and the fourth source/drain electrode may be on the single common gate insulating layer, and the third source/drain electrode may extend to a surface of the second source/drain electrode along a sidewall of the single common gate insulating layer.

In an example embodiment, the inverter may further include a substrate, wherein the second channel layer, the third source/drain electrode, and the fourth source/drain electrode may be on the substrate, the single common gate insulating layer may be on the second channel layer, the single common gate electrode may be buried in the single common gate insulating layer, the first channel layer, the first source/drain electrode, and the second source/drain electrode may be on the single common gate insulating layer, and the second source/drain electrode may extend to a surface of the third source/drain electrode along a sidewall of the single common gate insulating layer.

According to an example embodiment of the disclosure, a memory device includes a first inverter and a second inverter cyclically connected in series to form a ring oscillator, a first access transistor configured to permit or block access to the first inverter, and a second access transistor configured to permit or block access to the second inverter, wherein the first inverter includes a first pull-up transistor and a first pull-down transistor, the second inverter includes a second pull-up transistor and a second pull-down transistor, the first pull-up transistor and the second pull-up transistor each include a first channel layer including a p-type oxide semiconductor based on tellurium oxide, and the first access transistor, the second access transistor, the first pull-down transistor, and the second pull-down transistor each include a second channel layer including an n-type oxide semiconductor based on indium oxide.

For example, the p-type oxide semiconductor may include TeₐX_{b}O or In_{c}Te_{d}Oₑ, where X may include at least one of selenium (Se), germanium (Ge), or sulfur (S), in TeₐX_{b}O, a ≥ 0.7 and b ≤ 0.3, c + d = 1, c ≤ 0.5, d ≥ 0.5, and e may be less than a stoichiometric value, and the n-type oxide semiconductor may include indium oxide doped with at least one element selected from gallium (Ga), zinc (Zn), tin (Sn), or tungsten (W).

According to an example embodiment of the disclosure, an electronic apparatus includes a main memory, an auxiliary storage, a central processing unit (CPU), and an input/output device, wherein the CPU includes a cache memory, an arithmetic logic unit, and a control unit, the cache memory includes a first inverter and a second inverter cyclically connected in series to form a ring oscillator, a first access transistor configured to permit or block access to the first inverter, and a second access transistor configured to permit or block access to the second inverter, the first inverter includes a first pull-up transistor and a first pull-down transistor, the second inverter includes a second pull-up transistor and a second pull-down transistor, the first pull-up transistor and the second pull-up transistor each include a first channel layer including a p-type oxide semiconductor based on tellurium oxide, and the first access transistor, the second access transistor, the first pull-down transistor, and the second pull-down transistor each include a second channel layer including an n-type oxide semiconductor based on indium oxide.

### BRIEF DESCRIPTION OF THE DRAWINGS

The above and other aspects, features, and/or advantages of certain example embodiments of the disclosure will be more apparent from the following description taken in conjunction with the accompanying drawings, in which:
FIG. 1 schematically illustrates a circuit diagram of an inverter according to an example embodiment;
FIG. 2 is a graph showing an example of a current-voltage characteristic of a p-type field-effect transistor;
FIG. 3 is a graph showing an example of a current-voltage characteristic of an n-type field-effect transistor;
FIG. 4A is a graph showing an example of a density of states (DOS) for energy of indium tellurium oxide having a composition of Te:ln=3:1;
FIG. 4B is a graph showing an example of a DOS for energy of indium tellurium oxide having a composition of Te:In=1:3;
FIG. 5A is a graph showing an example of a DOS for energy when a composition is Te:In = 1:1 and an oxygen content is 20 % less than a stoichiometric value;
FIG. 5B is a graph showing an example of a DOS for energy when a composition is Te:In = 1:1 and an oxygen content is 10 % less than a stoichiometric value;
FIG. 5C is a graph showing an example of a DOS for energy when a composition is Te:In = 1:1 and an oxygen content has a stoichiometric value;
FIG. 6 is a cross-sectional view illustrating a schematic structure of the inverter illustrated in FIG. 1;
FIG. 7 is a cross-sectional view illustrating a schematic structure of an inverter according to another example embodiment;
FIG. 8 is a cross-sectional view illustrating a schematic structure of an inverter according to another example embodiment;
FIG. 9 is a cross-sectional view illustrating a schematic structure of an inverter according to another example embodiment;
FIG. 10 schematically illustrates a circuit diagram of a memory device according to an example embodiment;
FIG. 11 is a cross-sectional view illustrating a schematic structure of a first inverter of the memory device illustrated in FIG. 10;
FIG. 12 is a cross-sectional view illustrating a schematic structure of a first inverter and a first access transistor of the memory device illustrated in FIG. 10; and
FIG. 13 is a conceptual diagram schematically illustrating a device architecture applicable to an electronic apparatus, according to an example embodiment.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "one of," "one or more of," "any one of," "at least one of," "at least one among," and "at least one selected from," when preceding a list of elements, modify the entire list of elements and do not modify the individual elements of the list. For example, an expression such as "at least one of A, B, and C" or "at least one selected from the group consisting of A, B, and C" may be interpreted as only A, only B, only C, or any combination of two or more of A, B, and C, such as A, B, and C, A and B, B and C, and A and C.

While the term "same," "equal," or "identical" is used in the description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially," or "approximately" is used in this specification in connection with a numerical value, it is intended that the associated numerical value includes a manufacturing or operational tolerance (e.g., ±10%) around the stated numerical value. Moreover, when the word "about," "substantially," or "approximately" is used in connection with geometric shapes, it is intended that the precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

It will be understood that, although the terms first, second, third, etc. may be used herein to describe various elements, components, regions, layers, and/or sections, these elements, components, regions, layers, and/or sections should not be limited by these terms. These terms are only used to distinguish one element, component, region, layer, or section from another region, layer, or section. Thus, a first element, component, region, layer, or section discussed below could be termed a second element, component, region, layer, or section without departing from the teachings of example embodiments.

Hereinafter, an inverter including an oxide semiconductor, a memory device including the inverter, and an electronic apparatus including the memory device are described in detail with reference to the accompanying drawings. In the following drawings, the same reference numerals denote the same elements, and the size of each element in the drawings may be exaggerated for clarity and convenience of explanation. In addition, some example embodiments described herein are merely examples, and various modifications may be made thereto from these example embodiments.

Hereinafter, the terms "above," "on," "below," or "under" may include not only those that are directly above, below, left, or right in a contact manner, but also those that are above, below, left, or right in a non-contact manner. The singular forms as used herein are intended to include the plural forms as well, unless the context clearly indicates otherwise. It will be understood that the terms "comprise," "include," or "have" as used herein specify the presence of stated elements, but do not preclude the presence or addition of one or more other elements.

The use of the term "the" and similar demonstratives may correspond to both the singular and the plural. Operations constituting methods may be performed in any suitable order unless otherwise indicated herein or otherwise clearly contradicted by context, and are not necessarily limited to the stated order.

Also, the terms such as "unit" and "module" described in the specification mean units that process at least one function or operation, and may be implemented as hardware, software, or a combination of hardware and software.

Connecting lines or connecting members illustrated in the drawings are intended to represent exemplary functional relationships and/or physical or logical connections between the various elements. It should be noted that many alternative or additional functional relationships, physical connections or logical connections may be present in a practical device.

The use of all illustrations or illustrative terms in the example embodiments described below is simply to describe the technical ideas in detail, and the scope of the disclosure is not limited by the illustrations or illustrative terms unless they are limited by claims.

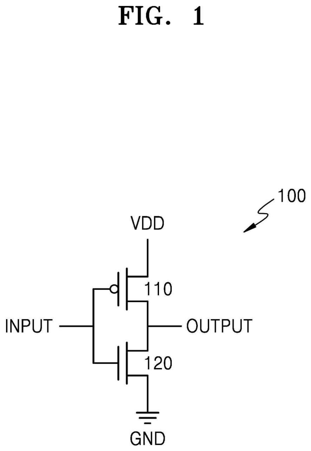

FIG. 1 schematically illustrates a circuit diagram of an inverter 100 according to an example embodiment. The inverter 100 may be, for example, a complementary metal-oxide semiconductor (CMOS) inverter. Referring to FIG. 1, the inverter 100 may include a p-type field-effect transistor 110 and an n-type field-effect transistor 120, which are connected between a power terminal VDD and a ground terminal GND. For example, one source/drain electrode of the p-type field-effect transistor 110 may be electrically connected to the power terminal VDD, one source/drain electrode of the n-type field-effect transistor 120 may be electrically connected to the ground terminal GND, and the other source/drain electrode of the p-type field-effect transistor 110 and the other source/drain electrode of the n-type field-effect transistor 120 may be electrically connected to each other. A gate of the p-type field-effect transistor 110 and a gate of the n-type field-effect transistor 120 may be electrically connected to a common input terminal. In addition, the source/drain electrodes of the p-type field-effect transistor 110 and the n-type field-effect transistor 120, which are electrically connected to each other, may be electrically connected to a common output terminal.

The p-type field-effect transistor 110 is a p-type metal-oxide semiconductor field-effect transistor (PMOS FET) and has a negative threshold voltage lower than 0 V. The n-type field-effect transistor 120 is an n-type metal-oxide semiconductor field-effect transistor (NMOS FET) and has a positive threshold voltage higher than 0 V. Accordingly, when a voltage (e.g., signal "1") higher than the positive threshold voltage is applied to the input terminal, the p-type field-effect transistor 110 may be turned off and the n-type field-effect transistor 120 may be turned on, and thus, the output terminal may be electrically connected to the ground terminal GND. In other words, when signal "1" is input to the input terminal, signal "0" may be output from the output terminal. When a voltage (e.g., signal "0") lower than the negative threshold voltage is applied to the input terminal, the p-type field-effect transistor 110 may be turned on and the n-type field-effect transistor 120 may be turned off, and thus, the output terminal may be electrically connected to the power terminal VDD. In other words, when signal "0" is input to the input terminal, signal "1" may be output from the output terminal.

According to an example embodiment, each of the p-type field-effect transistor 110 and the n-type field-effect transistor 120 may include an oxide semiconductor material as a channel layer. For example, the channel layer of the p-type field-effect transistor 110 may include a p-type oxide semiconductor material, and the channel layer of the n-type field-effect transistor 120 may include an n-type oxide semiconductor material.

For example, the p-type oxide semiconductor material may include an oxide semiconductor based on tellurium oxide (TeOₓ). The p-type oxide semiconductor material may include only tellurium oxide, or tellurium oxide may be further doped with at least one metal or non-metal element selected from selenium (Se), germanium (Ge), or sulfur (S). For example, the p-type oxide semiconductor material may include TeₐX_{b}O, where X may include at least one of selenium (Se), germanium (Ge), or sulfur (S). Tellurium (Te) may be included in an amount of about 70 at% or more and the remaining metal or non-metal elements may be included in an amount of about 30 at% or less, among all elements in the p-type oxide semiconductor material excluding oxygen. For example, in TeₐX_{b}O, a ≥ 0.7 and b ≤ 0.3.

For example, the n-type oxide semiconductor material may include an oxide semiconductor based on indium oxide (InOₓ). The n-type oxide semiconductor material may include only indium oxide, or indium oxide may be further doped with at least one metal element selected from gallium (Ga), zinc (Zn), tin (Sn), or tungsten (W). For example, the n-type oxide semiconductor material may include InₐGa_{b}Zn_{c}O. In InₐGa_{b}Zn_{c}O, a, b, and c may be equal to each other. In other words, the n-type oxide semiconductor material may include an oxide semiconductor based on indium oxide (InOₓ) having a composition in which the proportions of indium (In), gallium (Ga), and zinc (Zn) are substantially equal to each other. For example, in InₐGa_{b}Zn_{c}O, a = b = c = 0.33.

The oxide semiconductor based on tellurium oxide may have a relatively high hole field-effect mobility, compared to, for example, other oxide semiconductors based on tin oxide (SnO). For example, a hole field-effect mobility of the oxide semiconductor based on tellurium oxide may be substantially similar to an electron field-effect mobility of the oxide semiconductor based on indium oxide. Accordingly, the p-type field-effect transistor 110 may have a field-effect mobility and an on/off current ratio substantially similar to those of the n-type field-effect transistor 120. In addition, because the p-type field-effect transistor 110 and the n-type field-effect transistor 120 have similar performance, the channel of the p-type field-effect transistor 110 and the channel of the n-type field-effect transistor 120 may have substantially the same size.

Accordingly, the inverter 100 according to an example embodiment may have relatively high gain characteristics. In addition, because both the p-type field-effect transistor 110 and the n-type field-effect transistor 120 of the inverter 100 use the oxide semiconductor as a channel layer material, a leakage current may be reduced, and thus, power consumption of the inverter 100 may be reduced.

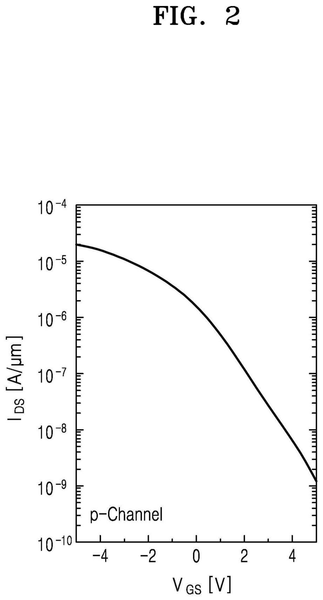

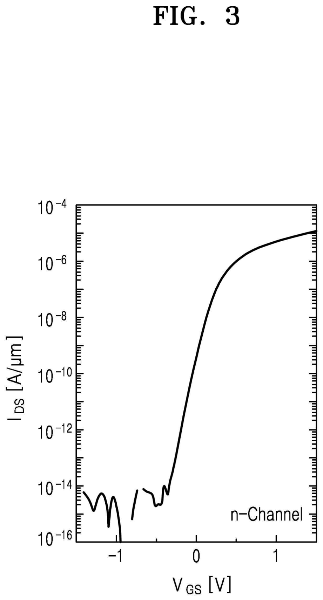

FIG. 2 is a graph showing an example of a current-voltage characteristic of the p-type field-effect transistor 110, and FIG. 3 is a graph showing an example of a current-voltage characteristic of the n-type field-effect transistor 120. The channel layer of the p-type field-effect transistor 110 in FIG. 2 includes TeₐSe_{b}O (a = 0.7, b = 0.3), and the channel layer of the n-type field-effect transistor 120 in FIG. 3 includes InₐGa_{b}Zn_{c}O (a, b, c = 0.33). In FIGS. 2 and 3, the on current of the p-type field-effect transistor 110 is about 20.1 mA/mm, and the on current of the n-type field-effect transistor 120 is about 10.9 mA/mm. In addition, the mobility of the p-type field-effect transistor 110 is about 7.95 cm²/Vs, and the mobility of the n-type field-effect transistor 120 is about 9.55 cm²/Vs. In addition, the channel layer of the p-type field-effect transistor 110 and the channel layer of the n-type field-effect transistor 120 each have a width of 10 µm. Accordingly, when the widths of the channel layers are equal to each other, the performance of the p-type field-effect transistor 110 having a TeₐSe_{b}O (a = 0.7, b = 0.3) channel layer may be substantially similar to or superior to the performance of the n-type field-effect transistor 120.

In another example, the oxide semiconductor based on tellurium oxide (TeOₓ) in the channel layer of the p-type field-effect transistor 110 may include amorphous indium tellurium oxide (InₐTe_{b}O_{c}). In InₐTe_{b}O_{c}, a + b = 1, a ≤ 0.5, b ≥ 0.5, and c may be less than a stoichiometric value. Accordingly, when the channel layer of the p-type field-effect transistor 110 includes indium tellurium oxide (InₐTe_{b}O_{c}), the channel layer may have a stoichiometrically oxygen-deficient composition. For example, in a stoichiometric reaction system of In, Te, and O, when a = 0.5 and b = 0.5, the stoichiometric value of oxygen may be 1.75, and thus c may be less than 1.75. For example, when a =0.25 and b = 0.75, the stoichiometric value of oxygen may be 1.875, and thus c may be less than 1.875.

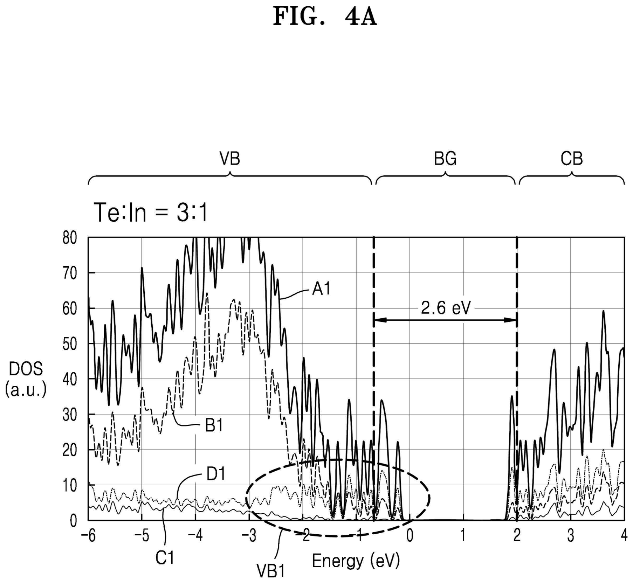

FIG. 4A is a graph showing an example of a density of states (DOS) for energy of indium tellurium oxide having a composition of Te:ln = 3:1. An oxygen content c is 1.875. In FIG. 4A, a graph A1 shows a DOS for the entire indium tellurium oxide, a graph B1 shows a DOS for oxygen, a graph C1 shows a DOS for indium, and a graph D1 shows a DOS for tellurium. A region VB1 where the DOSs for indium, tellurium, and oxygen are relatively low and widely distributed appears at a valence band boundary. The region VB1 shows that indium tellurium oxide having a composition of Te:ln = 3:1 has p-type semiconductor characteristics. In this case, a tellurium-related shallow state is formed near a valence band maximum (VBM), and thus, hole-doped p-type semiconductor characteristics are shown.

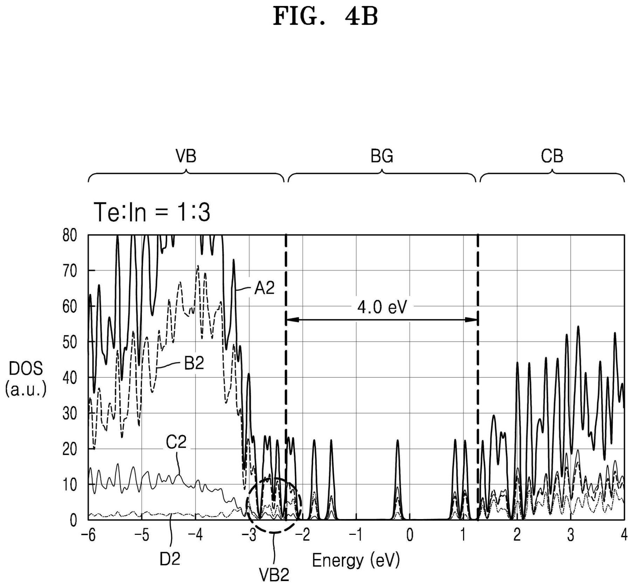

FIG. 4B is a graph showing an example of a DOS for energy of indium tellurium oxide having a composition of Te:In = 1:3. An oxygen content c is 1.625. In FIG. 4B, a graph A2 shows a DOS for the entire indium tellurium oxide, a graph B2 shows a DOS for oxygen, a graph C2 shows a DOS for indium, and a graph D2 shows a DOS for tellurium. A region VB2 where the DOSs for indium, tellurium, and oxygen are relatively low and widely distributed appears to be very narrow at a valence band boundary. This shows that indium tellurium oxide having a composition of Te:ln = 1:3 hardly exhibits p-type semiconductor characteristics.

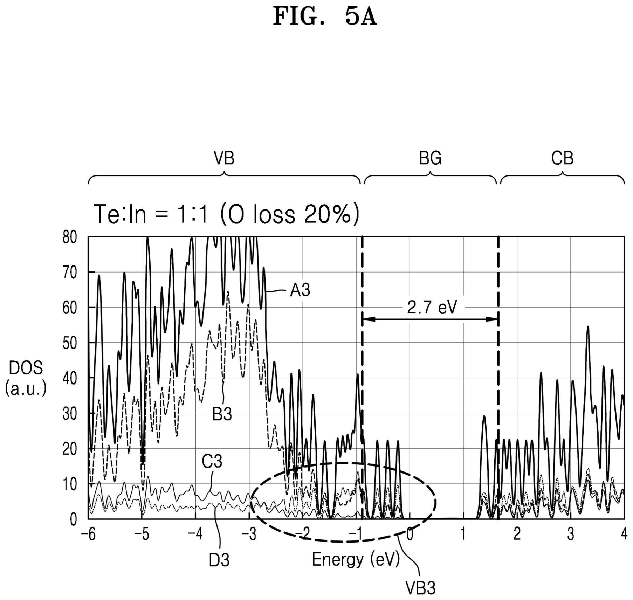

FIG. 5A is a graph showing an example of a DOS for energy when a composition is Te:In = 1:1 and an oxygen content is 20 % less than a stoichiometric value. An amount of oxygen deficiency relative to a stoichiometric value is defined as an oxygen vacancy concentration. FIG. 5A shows a case where, when a stoichiometric value of oxygen is 1.75, an oxygen vacancy concentration is 20 % and an oxygen content c is 1.4. In FIG. 5A, a graph A3 shows a DOS for the entire indium tellurium oxide, a graph B3 shows a DOS for oxygen, a graph C3 shows a DOS for indium, and a graph D3 shows a DOS for tellurium. A region VB3 where the DOSs for tellurium, indium, and oxygen are low and widely distributed appears at a valence band boundary. Accordingly, indium tellurium oxide exhibits p-type semiconductor characteristics when the oxygen content is 20 % less than the stoichiometric value.

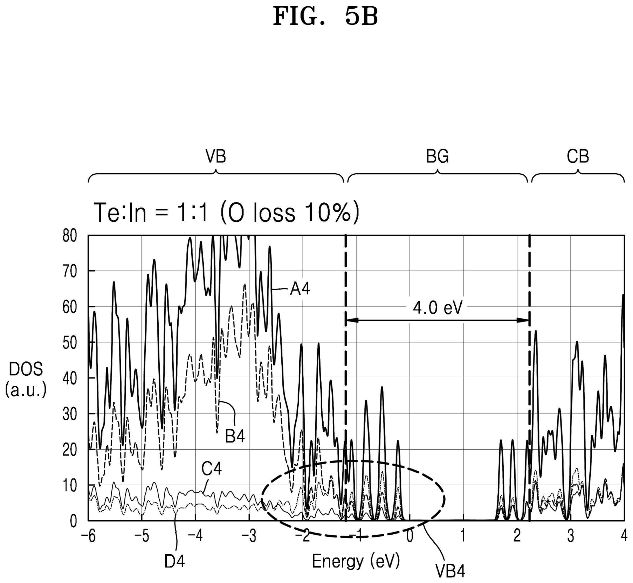

FIG. 5B is a graph showing an example of a DOS for energy when a composition is Te:In = 1:1 and an oxygen content is 10 % less than a stoichiometric value. FIG. 5B shows a case where, when a stoichiometric value of oxygen is 1.75, an oxygen vacancy concentration is 10 % and an oxygen content c is 1.575. In FIG. 5B, a graph A4 shows a DOS for the entire indium tellurium oxide, a graph B4 shows a DOS for oxygen, a graph C4 shows a DOS for indium, and a graph D4 shows a DOS for tellurium. A region VB4 where the DOSs for tellurium, indium, and oxygen are relatively low and widely distributed appears at a conduction band boundary. Accordingly, indium tellurium oxide exhibits p-type semiconductor characteristics when the oxygen content is 10 % less than the stoichiometric value.

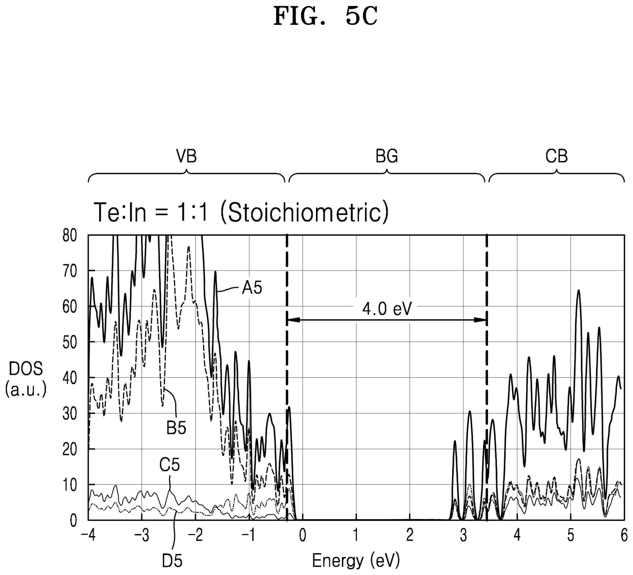

FIG. 5C is a graph showing an example of a DOS for energy when a composition is Te:In = 1:1 and an oxygen content has a stoichiometric value of 1.75. In FIG. 5C, a graph A5 shows a DOS for the entire indium tellurium oxide, a graph B5 shows a DOS for oxygen, a graph C5 shows a DOS for indium, and a graph D5 shows a DOS for tellurium. In FIG. 5C, the DOSs for tellurium, indium, and oxygen at the valence band boundary hardly exhibit p-type semiconductor characteristics.

Referring to FIGS. 5A to 5C, the channel layer may include indium tellurium oxide having a stoichiometrically oxygen-deficient composition. In addition, relatively stronger p-type semiconductor characteristics may be exhibited when an oxygen vacancy concentration is 20 %, compared to 10 %. Accordingly, as the oxygen vacancy concentration increases, the p-type semiconductor characteristics may be more clearly exhibited. For example, the oxygen vacancy concentration may be 5 % to 80 %, 10 % to 70 %, or 10 % to 60 %. As described above, the channel layer of the p-type field-effect transistor 110 may include indium tellurium oxide (InₐTe_{b}O_{c}), where a + b = 1, a ≤ 0.5, b ≥ 0.5, and c may be less than the stoichiometric value. For example, c < 1.875, c < 1.8, or c < 1.75.

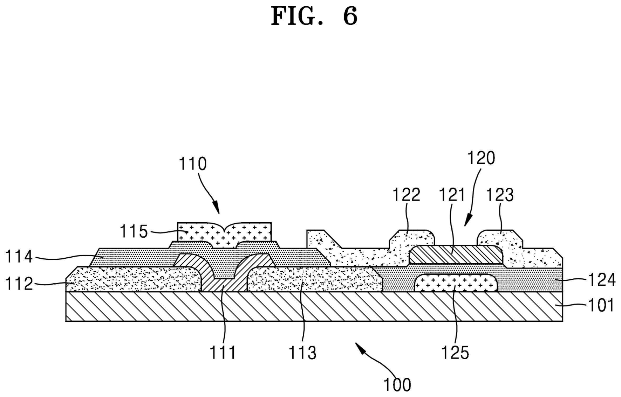

FIG. 6 is a cross-sectional view illustrating a schematic structure of the inverter 100 illustrated in FIG. 1. The p-type field-effect transistor 110 and the n-type field-effect transistor 120 of the inverter 100 may be adjacent to each other in a horizontal direction on a single substrate 101. The inverter 100 may be a planar inverter.

Referring to FIG. 6, the p-type field-effect transistor 110 (or, a first field-effect transistor) may include a first channel layer 111 disposed on the substrate 101, a first source/drain electrode 112 disposed on the substrate 101 and electrically connected to a first side surface of the first channel layer 111, a second source/drain electrode 113 disposed on the substrate 101 and electrically connected to a second side surface opposite to the first side surface of the first channel layer 111 in a horizontal direction (e.g., a first direction) parallel to an upper surface of the substrate 101, a first gate insulating layer 114 disposed to cover the first source/drain electrode 112, the first channel layer 111, and the second source/drain electrode 113, and a first gate electrode 115 disposed on the first gate insulating layer 114 to face the first channel layer 111 in a direction (e.g., a second direction) perpendicular to the upper surface of the substrate 101. The first source/drain electrode 112 and the second source/drain electrode 113 may be disposed on the substrate 101 and spaced apart from each other on opposite sides of the first channel layer 111 in the first direction. The first channel layer 111 may be disposed between the first source/drain electrode 112 and the second source/drain electrode 113. The first gate insulating layer 114 may be disposed between the first channel layer 111 and the first gate electrode 115.

As described above, the first channel layer 111 may include a p-type oxide semiconductor material. The first channel layer 111 may include, for example, an oxide semiconductor based on amorphous tellurium oxide (TeOₓ). In an example, the oxide semiconductor material of the first channel layer 111 may include tellurium oxide doped with at least one metal or non-metal element selected from selenium (Se), germanium (Ge), or sulfur (S). For example, the first channel layer 111 may include TeₐX_{b}O, where X may include at least one of selenium (Se), germanium (Ge), or sulfur (S), a ≥ 0.7, and b ≤ 0.3. In another example, the first channel layer 111 may include amorphous indium tellurium oxide (InₐTe_{b}O_{c}), where a + b = 1, a ≤ 0.5, b ≥ 0.5, and c may be less than a stoichiometric value.

The n-type field-effect transistor 120 (or a second field-effect transistor) may include a second gate electrode 125 disposed on the substrate 101, a second gate insulating layer 124 disposed to cover the substrate 101 and the second gate electrode 125, a second channel layer 121 disposed on the second gate insulating layer 124 to face the second gate electrode 125 in the second direction, a third source/drain electrode 122 disposed on the second gate insulating layer 124 and electrically connected to a first side surface of the second channel layer 121, and a fourth source/drain electrode 123 disposed on the second gate insulating layer 124 and electrically connected to a second side surface opposite to the first side surface of the second channel layer 121 in the first direction. The third source/drain electrode 122 and the fourth source/drain electrode 123 may be disposed on the second gate insulating layer 124 and spaced apart from each other on opposite sides of the second channel layer 121 in the first direction. The second channel layer 121 may be disposed between the third source/drain electrode 122 and the fourth source/drain electrode 123. The second gate insulating layer 124 may be disposed between the second channel layer 121 and the second gate electrode 125.

The second gate insulating layer 124 of the n-type field-effect transistor 120 may extend in the first direction so as to come into contact with a side surface of the second source/drain electrode 113 of the p-type field-effect transistor 110. An upper surface of the second source/drain electrode 113 of the p-type field-effect transistor 110 may be at least partially exposed between the first gate insulating layer 114 of the p-type field-effect transistor 110 and the second gate insulating layer 124 of the n-type field-effect transistor 120. The third source/drain electrode 122 of the n-type field-effect transistor 120 may extend over the exposed upper surface of the second source/drain electrode 113 of the p-type field-effect transistor 110. Accordingly, the second source/drain electrode 113 of the p-type field-effect transistor 110 and the third source/drain electrode 122 of the n-type field-effect transistor 120 may be electrically connected to each other.

In the inverter 100 illustrated in FIG. 6, the first source/drain electrode 112 of the p-type field-effect transistor 110 may be electrically connected to the power terminal VDD, and the fourth source/drain electrode 123 of the n-type field-effect transistor 120 may be connected to the ground terminal GND. In addition, the first gate electrode 115 of the p-type field-effect transistor 110 and the second gate electrode 125 of the n-type field-effect transistor 120 may be electrically connected to the input terminal, and the second source/drain electrode 113 of the p-type field-effect transistor 110 and the third source/drain electrode 122 of the n-type field-effect transistor 120 may be electrically connected to the output terminal.

The second channel layer 121 of the n-type field-effect transistor 120 may include an n-type oxide semiconductor material. The second channel layer 121 may include, for example, an oxide semiconductor based on amorphous indium oxide (InOₓ). In an example, the oxide semiconductor material of the second channel layer 121 may include indium oxide doped with at least one metal element selected from gallium (Ga), zinc (Zn), tin (Sn), or tungsten (W). For example, the second channel layer 121 may include InₐGa_{b}Zn_{c}O (a = b = c).

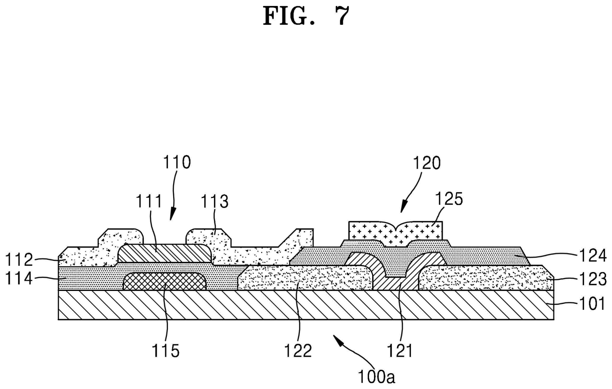

FIG. 7 is a cross-sectional view illustrating a schematic structure of an inverter 100a according to another example embodiment. Although FIG. 6 illustrates the p-type field-effect transistor 110 having a top gate structure and the n-type field-effect transistor 120 having a bottom gate structure, the disclosure is not limited thereto. For example, the inverter 100a illustrated in FIG. 7 may include a p-type field-effect transistor 110 having a bottom gate structure and an n-type field-effect transistor 120 having a top gate structure.

Referring to FIG. 7, the p-type field-effect transistor 110 may include a first gate electrode 115 disposed on a substrate 101, a first gate insulating layer 114 disposed to cover the substrate 101 and the first gate electrode 115, a first channel layer 111 disposed on the first gate insulating layer 114 to face the first gate electrode 115 in a second direction, a first source/drain electrode 112 disposed on the first gate insulating layer 114 and electrically connected to a first side surface of the first channel layer 111, and a second source/drain electrode 113 disposed on the first gate insulating layer 114 and electrically connected to a second side surface opposite to the first side surface of the first channel layer 111 in a first direction. The first source/drain electrode 112 and the second source/drain electrode 113 may be disposed on the first gate insulating layer 114 and spaced apart from each other on opposite sides of the first channel layer 111 in the first direction.

The n-type field-effect transistor 120 may include a second channel layer 121 disposed on the substrate 101, a third source/drain electrode 122 disposed on the substrate 101 and electrically connected to a first side surface of the second channel layer 121, a fourth source/drain electrode 123 disposed on the substrate 101 and electrically connected to a second side surface opposite to the first side surface of the second channel layer 121 in the first direction, a second gate insulating layer 124 disposed to cover the third source/drain electrode 122, the second channel layer 121, and the fourth source/drain electrode 123, and a second gate electrode 125 disposed on the second gate insulating layer 124 to face the second channel layer 121 in the second direction. The third source/drain electrode 122 and the fourth source/drain electrode 123 may be disposed on the substrate 101 and spaced apart from each other on opposite sides of the second channel layer 121 in the first direction.

The first gate insulating layer 114 of the p-type field-effect transistor 110 may extend in the first direction so as to come into contact with a side surface of the third source/drain electrode 122 of the n-type field-effect transistor 120. An upper surface of the third source/drain electrode 122 of the n-type field-effect transistor 120 may be at least partially exposed between the first gate insulating layer 114 of the p-type field-effect transistor 110 and the second gate insulating layer 124 of the n-type field-effect transistor 120. The second source/drain electrode 113 of the p-type field-effect transistor 110 may extend over the exposed upper surface of the third source/drain electrode 122 of the n-type field-effect transistor 120. In this manner, the second source/drain electrode 113 of the p-type field-effect transistor 110 and the third source/drain electrode 122 of the n-type field-effect transistor 120 may be electrically connected to each other.

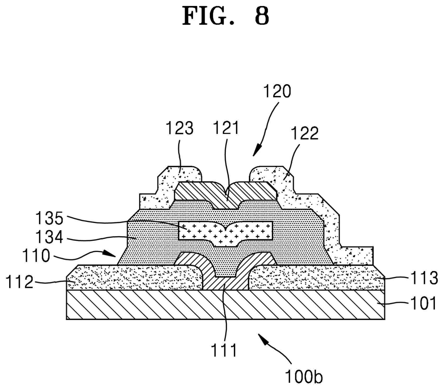

FIG. 8 is a cross-sectional view illustrating a schematic structure of an inverter 100b according to another example embodiment. Although the structure in which the p-type field-effect transistor 110 and the n-type field-effect transistor 120 are disposed on the substrate 101 in a planar form has been described with reference to FIGS. 6 and 7, the p-type field-effect transistor 110 and the n-type field-effect transistor 120 may be disposed in a stacked form. Referring to FIG. 8, the inverter 100b may include a p-type field-effect transistor 110 disposed on a substrate 101 and an n-type field-effect transistor 120 stacked on the p-type field-effect transistor 110.

For example, the inverter 100b may include a first channel layer 111 disposed on the substrate 101, a first source/drain electrode 112 disposed on the substrate 101 and electrically connected to a first side surface of the first channel layer 111, a second source/drain electrode 113 disposed on the substrate 101 and electrically connected to a second side surface opposite to the first side surface of the first channel layer 111 in a first direction, a common gate insulating layer 134 disposed to cover the first source/drain electrode 112, the first channel layer 111, and the second source/drain electrode 113, a common gate electrode 135 disposed within the common gate insulating layer 134 to face the first channel layer 111 in a second direction, a second channel layer 121 disposed on the common gate insulating layer 134 to face the common gate electrode 135 in the second direction, a third source/drain electrode 122 disposed on the common gate insulating layer 134 and electrically connected to a first side surface of the second channel layer 121, and a fourth source/drain electrode 123 disposed on the common gate insulating layer 134 and electrically connected to a second side surface opposite to the first side surface of the second channel layer 121 in the first direction.

The p-type field-effect transistor 110 may include the first channel layer 111, the first source/drain electrode 112, the second source/drain electrode 113, the common gate insulating layer 134, and the common gate electrode 135. The n-type field-effect transistor 120 may include the second channel layer 121, the third source/drain electrode 122, the fourth source/drain electrode 123, the common gate insulating layer 134, and the common gate electrode 135. The common gate insulating layer 134 may be a gate insulating layer shared by the p-type field-effect transistor 110 and the n-type field-effect transistor 120. In other words, a first gate insulating layer of the p-type field-effect transistor 110 and a second gate insulating layer of the n-type field-effect transistor 120 may be formed as or constitute one common gate insulating layer 134. The common gate electrode 135 may be a gate electrode shared by the p-type field-effect transistor 110 and the n-type field-effect transistor 120. In other words, a first gate electrode of the p-type field-effect transistor 110 and a second gate electrode of the n-type field-effect transistor 120 may be formed as or constitute one common gate electrode 135. In this case, the common gate electrode 135 may be electrically connected to an input terminal of the inverter 100b. The common gate insulating layer 134 may be disposed to surround an upper surface, a lower surface, a first side surface, and a second side surface of the common gate electrode 135. Accordingly, the common gate electrode 135 may be buried in the common gate insulating layer 134.

An upper surface or a sidewall of the second source/drain electrode 113 of the p-type field-effect transistor 110 may be at least partially exposed so as not to be covered by the common gate insulating layer 134. The third source/drain electrode 122 of the n-type field-effect transistor 120 may extend to the exposed surface of the second source/drain electrode 113 of the p-type field-effect transistor 110 along a sidewall of the common gate insulating layer 134. Accordingly, the second source/drain electrode 113 of the p-type field-effect transistor 110 and the third source/drain electrode 122 of the n-type field-effect transistor 120 may be electrically connected to each other.

According to the above-described example embodiment, the p-type field-effect transistor 110 and the n-type field-effect transistor 120 may be formed in a vertically stacked structure, and thus, the integration density of the entire circuit including the inverter 100b may be improved. In addition, the stacked structure may further reduce leakage current.

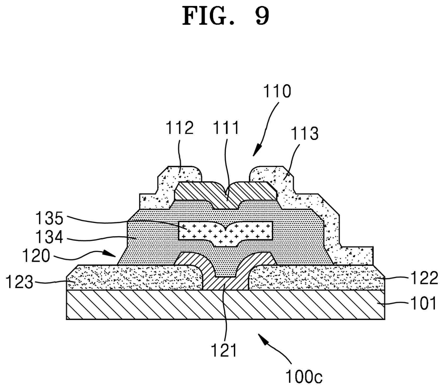

FIG. 9 is a cross-sectional view illustrating a schematic structure of an inverter 100c according to another example embodiment. Although a case where the n-type field-effect transistor 120 is stacked on the p-type field-effect transistor 110 has been described with reference to FIG. 8, the disclosure is not necessarily limited thereto. Referring to FIG. 9, the inverter 100c may include an n-type field-effect transistor 120 disposed on a substrate 101 and a p-type field-effect transistor 110 stacked on the n-type field-effect transistor 120.

The inverter 100c may include a second channel layer 121 disposed on the substrate 101, a third source/drain electrode 122 disposed on the substrate 101 and electrically connected to a first side surface of the second channel layer 121, a fourth source/drain electrode 123 disposed on the substrate 101 and electrically connected to a second side surface opposite to the first side surface of the second channel layer 121 in a first direction, a common gate insulating layer 134 disposed to cover the third source/drain electrode 122, the second channel layer 121, and the fourth source/drain electrode 123, a common gate electrode 135 disposed within the common gate insulating layer 134 to face the second channel layer 121 in a second direction, a first channel layer 111 disposed on the common gate insulating layer 134 to face the common gate electrode 135 in the second direction, a first source/drain electrode 112 disposed on the common gate insulating layer 134 and electrically connected to a first side surface of the first channel layer 111, and a second source/drain electrode 113 disposed on the common gate insulating layer 134 and electrically connected to a second side surface opposite to the first side surface of the first channel layer 111 in the first direction.

An upper surface or a sidewall of the third source/drain electrode 122 of the n-type field-effect transistor 120 may be at least partially exposed so as not to be covered by the common gate insulating layer 134. The second source/drain electrode 113 of the p-type field-effect transistor 110 may extend to the exposed surface of the third source/drain electrode 122 of the n-type field-effect transistor 120 along a sidewall of the common gate insulating layer 134.

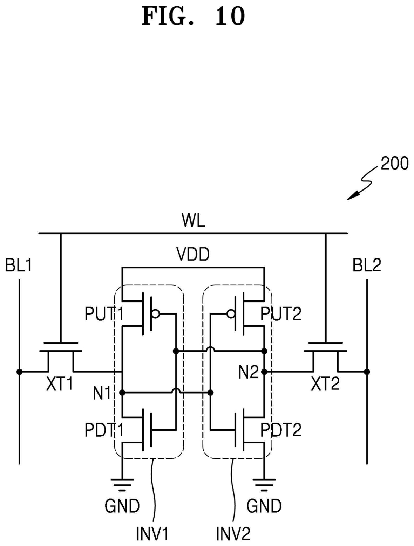

The inverter according to the embodiment may be applied to semiconductor devices and electronic apparatuses, such as memory devices. FIG. 10 schematically illustrates a circuit diagram of a memory device 200 according to an example embodiment. The memory device 200 illustrated in FIG. 10 may be, for example, a static random-access memory (SRAM). The memory device 200 may include a plurality of memory cells that are two-dimensionally disposed. FIG. 10 illustrates an example of a circuit configuration of a memory cell of the memory device 200.

Referring to FIG. 10, the memory cell of the memory device 200 may include six transistors. For example, the memory cell of the memory device 200 may include a first access transistor XT1, a second access transistor XT2, a first pull-up transistor PUT1, a second pull-up transistor PUT2, a first pull-down transistor PDT1, and a second pull-down transistor PDT2.

The first pull-up transistor PUT1 and the second pull-up transistor PUT2 may each be a p-type field-effect transistor (e.g., a PMOS FET), and the first access transistor XT1, the second access transistor XT2, the first pull-down transistor PDT1, and the second pull-down transistor PDT2 may each be an n-type field-effect transistor (e.g., an NMOS FET). The first pull-up transistor PUT1 and the first pull-down transistor PDT1 may form a first inverter INV1 and may act as a storage element. In addition, the second pull-up transistor PUT2 and the second pull-down transistor PDT2 may form a second inverter INV2 and may act as a storage element. The first and second pull-up transistors PUT1 and PUT2 may be electrically connected to a power terminal VDD, and the first and second pull-down transistors PDT1 and PDT2 may be electrically connected to a ground terminal GND.

The first inverter INV1 and the second inverter INV2 may be cyclically connected in series to form a ring oscillator (or a cross-coupled bistable latch). For example, an output terminal of the first inverter INV1 may be electrically connected to an input terminal of the second inverter INV2, and an output terminal of the second inverter INV2 may be electrically connected to an input terminal of the first inverter INV1. Signals input to the first inverter INV1 and the second inverter INV2 may be stored therein while circulating through the ring oscillator. Accordingly, the first inverter INV1 and the second inverter INV2 may operate together as one storage element.

The first and second access transistors XT1 and XT2 may permit access to the first inverter INV1 and the second inverter INV2, which are the storage elements, during data read and write operations, and may block access to the first inverter INV1 and the second inverter INV2 during a data hold operation. For example, the first access transistor XT1 may be provided to permit or block access to the first inverter INV1, and the second access transistor XT2 may be provided to permit or block access to the second inverter INV2.

A source of the first access transistor XT1 may be electrically connected to a first bit line BL1, and a drain of the first access transistor XT1 may be electrically connected to gate electrodes of the second pull-up transistor PUT2 and the second pull-down transistor PDT2 through a first node N1. A source of the second access transistor XT2 may be electrically connected to a second bit line BL2, and a drain of the second access transistor XT2 may be electrically connected to gate electrodes of the first pull-up transistor PUT1 and the first pull-down transistor PDT1 through a second node N2. Gates of the first and second access transistors XT1 and XT2 may be electrically connected to a word line WL.

According to an example embodiment, the first access transistor XT1, the second access transistor XT2, the first pull-up transistor PUT1, the second pull-up transistor PUT2, the first pull-down transistor PDT1, and the second pull-down transistor PDT2 of the memory device 200 may each include an oxide semiconductor material as a channel layer. For example, the channel layers of the first pull-up transistor PUT1 and the second pull-up transistor PUT2 may each include a p-type oxide semiconductor material, and the channel layers of the first access transistor XT1, the second access transistor XT2, the first pull-down transistor PDT1, and the second pull-down transistor PDT2 may each include an n-type oxide semiconductor material.

As described with reference to FIG. 1, the p-type oxide semiconductor material may include an oxide semiconductor based on tellurium oxide, and may be further doped with at least one metal or non-metal element selected from selenium (Se), germanium (Ge), or sulfur (S). For example, the p-type oxide semiconductor material may include TeₐX_{b}O, where X may include at least one of selenium (Se), germanium (Ge), or sulfur (S), a ≥ 0.7, and b ≤ 0.3. In another example, the p-type oxide semiconductor material may include amorphous indium tellurium oxide (InₐTe_{b}O_{c}), where a + b = 1, a ≤ 0.5, b ≥ 0.5, and c may be less than a stoichiometric value. In addition, the n-type oxide semiconductor material may include an oxide semiconductor based on indium oxide (InOₓ), and may be further doped with at least one metal element selected from gallium (Ga), zinc (Zn), tin (Sn), or tungsten (W). For example, the n-type oxide semiconductor material may include InₐGa_{b}Zn_{c}O (a = b = c). Accordingly, the first pull-up transistor PUT1 and the second pull-up transistor PUT2 may each be identical to the p-type field-effect transistor 110 described with reference to FIG. 1, and the first access transistor XT1, the second access transistor XT2, the first pull-down transistor PDT1, and the second pull-down transistor PDT2 may each be identical to the n-type field-effect transistor 120 described with reference to FIG. 1. In addition, the first inverter INV1 and the second inverter INV2 may each be identical to the inverter 100 described with reference to FIG. 1.

According to an example embodiment, because the oxide semiconductor is used as the material of the channel layer, the gains of the first inverter INV1 and the second inverter INV2 may be increased and the performance of the memory device 200 including the first inverter INV1 and the second inverter INV2 may be improved. For example, noise may be reduced in the read operation of the memory device 200, and/or leakage current may be reduced, and thus, power consumption of the memory device 200 may be reduced.

The first inverter INV1 and the second inverter INV2 may have a planar structure, like the inverter 100 illustrated in FIG. 6 or the inverter 100a illustrated in FIG. 7, or may have a stacked structure, like the inverter 100b illustrated in FIG. 8 or the inverter 100c illustrated in FIG. 9.

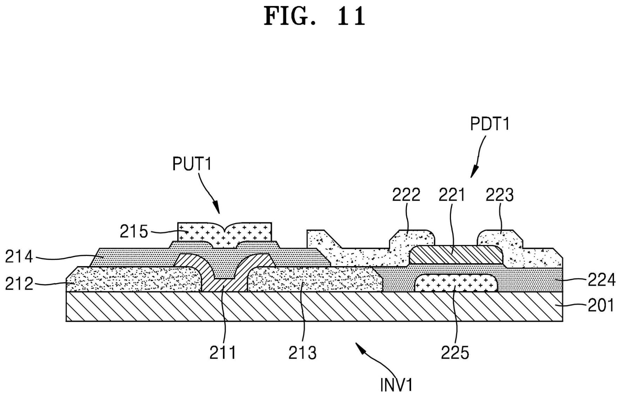

FIG. 11 is a cross-sectional view illustrating a schematic structure of the first inverter INV1 of the memory device 200 illustrated in FIG. 10. Referring to FIG. 11, the first pull-up transistor PUT1 and the first pull-down transistor PDT1 of the first inverter INV1 may be provided in a planar structure on the single substrate 201.

The first pull-up transistor PUT1 may include a first channel layer 211 disposed on the substrate 201, a first source/drain electrode 212 disposed on the substrate 201 and electrically connected to a first side surface of the first channel layer 211, a second source/drain electrode 213 disposed on the substrate 201 and electrically connected to a second side surface opposite to the first side surface of the first channel layer 211 in a first direction, a first gate insulating layer 214 disposed to cover the first source/drain electrode 212, the first channel layer 211, and the second source/drain electrode 213, and a first gate electrode 215 disposed on the first gate insulating layer 214 to face the first channel layer 211 in a second direction.

The first pull-down transistor PDT1 may include a second gate electrode 225 disposed on the substrate 201, a second gate insulating layer 224 disposed to cover the substrate 201 and the second gate electrode 225, a second channel layer 221 disposed on the second gate insulating layer 224 to face the second gate electrode 225 in the second direction, a third source/drain electrode 222 disposed on the second gate insulating layer 224 and electrically connected to a first side surface of the second channel layer 221, and a fourth source/drain electrode 223 disposed on the second gate insulating layer 224 and electrically connected to a second side surface opposite to the first side surface of the second channel layer 221 in the first direction.

The second gate insulating layer 224 of the first pull-down transistor PDT1 may extend in the first direction so as to come into contact with a side surface of the second source/drain electrode 213 of the first pull-up transistor PUT1. An upper surface of the second source/drain electrode 213 of the first pull-up transistor PUT1 may be at least partially exposed between the first gate insulating layer 214 of the first pull-up transistor PUT1 and the second gate insulating layer 224 of the first pull-down transistor PDT1. The third source/drain electrode 222 of the first pull-down transistor PDT1 may extend over the exposed upper surface of the second source/drain electrode 213 of the first pull-up transistor PUT1. In this manner, the second source/drain electrode 213 of the first pull-up transistor PUT1 and the third source/drain electrode 222 of the first pull-down transistor PDT1 may be electrically connected to each other.

Although FIG. 11 illustrates that the first pull-up transistor PUT1 has a top gate structure and the first pull-down transistor PDT1 has a bottom gate structure, the disclosure is not limited thereto. For example, the first inverter INV1 may include the first pull-up transistor PUT1 having a bottom gate structure and the first pull-down transistor PDT1 having a top gate structure. The second inverter INV2 may also have the same planar structure as the first inverter INV1 illustrated in FIG. 11.

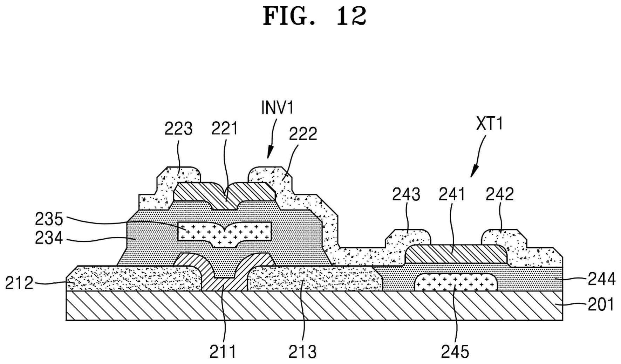

FIG. 12 is a cross-sectional view illustrating a schematic structure of the first inverter INV1 and the first access transistor XT1 of the memory device 200 illustrated in FIG. 10. Referring to FIG. 12, the first pull-up transistor PUT1 and the first pull-down transistor PDT1 may be provided in a stacked structure, and the first access transistor XT1 may be provided adjacent to the first inverter INV1 in a horizontal direction on the substrate 201.

The first inverter INV1 may include a first channel layer 211 disposed on the substrate 201, a first source/drain electrode 212 disposed on the substrate 201 and electrically connected to a first side surface of the first channel layer 211, a second source/drain electrode 213 disposed on the substrate 201 and electrically connected to a second side surface opposite to the first side surface of the first channel layer 211 in a first direction, a common gate insulating layer 234 disposed to cover the first source/drain electrode 212, the first channel layer 211, and the second source/drain electrode 213, a common gate electrode 235 disposed within the common gate insulating layer 234 to face the first channel layer 211 in a second direction, a second channel layer 221 disposed on the common gate insulating layer 234 to face the common gate electrode 235 in the second direction, a third source/drain electrode 222 disposed on the common gate insulating layer 234 and electrically connected to a first side surface of the second channel layer 221, and a fourth source/drain electrode 223 disposed on the common gate insulating layer 234 and electrically connected to a second side surface opposite to the first side surface of the second channel layer 221 in the first direction.

The first pull-up transistor PUT1 may include the first channel layer 211, the first source/drain electrode 212, the second source/drain electrode 213, the common gate insulating layer 234, and the common gate electrode 235. The first pull-down transistor PDT1 may include the second channel layer 221, the third source/drain electrode 222, the fourth source/drain electrode 223, the common gate insulating layer 234, and the common gate electrode 235. Accordingly, it may be said that the first pull-down transistor PDT1 is stacked on the first pull-up transistor PUT1. The common gate insulating layer 234 may be a gate insulating layer shared by the first pull-up transistor PUT1 and the first pull-down transistor PDT1. The common gate electrode 235 may be a gate electrode shared by the first pull-up transistor PUT1 and the first pull-down transistor PDT1. The common gate insulating layer 234 may be disposed to surround an upper surface, a lower surface, a first side surface, and a second side surface of the common gate electrode 235. Accordingly, the common gate electrode 235 may be buried in the common gate insulating layer 234.

An upper surface or a sidewall of the second source/drain electrode 213 of the first pull-up transistor PUT1 may be at least partially exposed so as not to be covered by the common gate insulating layer 234. The third source/drain electrode 222 of the first pull-down transistor PDT1 may extend to the exposed surface of the second source/drain electrode 213 of the first pull-up transistor PUT1 along a sidewall of the common gate insulating layer 234. In this manner, the second source/drain electrode 213 of the first pull-up transistor PUT1 and the third source/drain electrode 222 of the first pull-down transistor PDT1 may be electrically connected to each other.

The first access transistor XT1 may include a third gate electrode 245 disposed on the substrate 201, a third gate insulating layer 244 disposed to cover the substrate 201 and the third gate electrode 245, a third channel layer 241 disposed on the third gate insulating layer 244 to face the third gate electrode 245 in the second direction, a fifth source/drain electrode 242 disposed on the third gate insulating layer 244 and electrically connected to a first side surface of the third channel layer 241, and a sixth source/drain electrode 243 disposed on the third gate insulating layer 244 and electrically connected to a second side surface opposite to the first side surface of the third channel layer 241 in the first direction. The third channel layer 241 of the first access transistor XT1 may include an n-type oxide semiconductor material. The sixth source/drain electrode 243 of the first access transistor XT1 may extend in a lateral direction along an upper surface of the third gate insulating layer 244 so as to be electrically connected to the second source/drain electrode 213 of the first pull-up transistor PUT1 and the third source/drain electrode 222 of the first pull-down transistor PDT1. In an example embodiment, the third source/drain electrode 222 of the first pull-down transistor PDT1 and the sixth source/drain electrode 243 of the first access transistor XT1 may be integrally formed as a single electrode.

The stacked structure may reduce the size of the single memory cell of the memory device 200 and improve the storage capacity of the memory device 200.

Although FIG. 12 illustrates that the first pull-down transistor PDT1 is stacked on the first pull-up transistor PUT1, the first inverter INV1 may be formed so that the first pull-up transistor PUT1 is stacked on the first pull-down transistor PDT1. In addition, the second inverter INV2 and the second access transistor XT2 may have the same structure as that illustrated in FIG. 12.

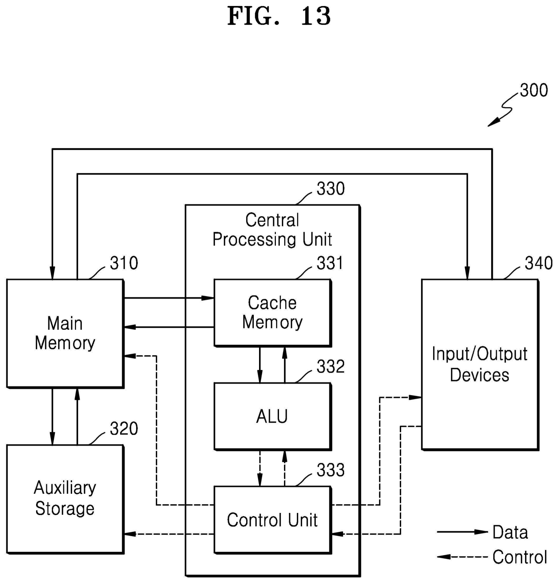

The memory device 200 described above may be applied to various electronic apparatuses. FIG. 13 is a conceptual diagram schematically illustrating a device architecture applicable to an electronic apparatus 300, according to an example embodiment. Referring to FIG. 13, the electronic apparatus 300 may include a main memory 310, an auxiliary storage 320, a central processing unit (CPU) 330, and an input/output device 340. The CPU 330 may include a cache memory 331, an arithmetic logic unit (ALU) 332, and a control unit 333. The cache memory 331 may be an SRAM and may include the memory device 200 according to the above-described example embodiment. The main memory 310 may include a dynamic random-access memory (DRAM). Alternatively, the cache memory 331, the main memory 310, and the auxiliary storage 320 may each include the memory device 200 according to the above-described example embodiment. In some cases, the electronic apparatus 300 may be implemented so that computing unit elements and memory unit elements are adjacent to each other on a single chip, without distinction of the above-described sub-units.

Any functional blocks shown in the figures and described above may be implemented in processing circuitry such as hardware including logic circuits, a hardware/software combination such as a processor executing software, or a combination thereof. For example, the processing circuitry may more specifically include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, an application-specific integrated circuit (ASIC), etc.

The example embodiments described above may be summarized as follows.
(1) An inverter according to an example embodiment may include a first field-effect transistor including a first channel layer, a first source/drain electrode and a second source/drain electrode spaced apart from each other on opposite sides of the first channel layer, a first gate electrode facing the first channel layer, and a first gate insulating layer between the first channel layer and the first gate electrode, and a second field-effect transistor including a second channel layer, a third source/drain electrode and a fourth source/drain electrode spaced apart from each other on opposite sides of the second channel layer, a second gate electrode facing the second channel layer, and a second gate insulating layer between the second channel layer and the second gate electrode, wherein the second source/drain electrode and the third source/drain electrode are electrically connected to each other, the first channel layer includes a p-type oxide semiconductor based on tellurium oxide, and the second channel layer includes an n-type oxide semiconductor based on indium oxide.
(2) For example, the p-type oxide semiconductor may include tellurium oxide doped with at least one element selected from selenium (Se), germanium (Ge), or sulfur (S).
(3) For example, the p-type oxide semiconductor may include TeₐX_{b}O, where X may include at least one of selenium (Se), germanium (Ge), or sulfur (S), a ≥ 0.7, and b ≤ 0.3.
(4) For example, the p-type oxide semiconductor may include InₐTe_{b}O_{c}, where a + b = 1, a ≤ 0.5, and b ≥ 0.5.
(5) For example, c in InₐTe_{b}O_{c} may be less than a stoichiometric value.
(6) For example, an oxygen vacancy concentration in InₐTe_{b}O_{c} may be about 5 % to about 80 %.
(7) For example, the n-type oxide semiconductor may include indium oxide doped with at least one element selected from gallium (Ga), zinc (Zn), tin (Sn), or tungsten (W).
(8) For example, the n-type oxide semiconductor may include InₐGa_{b}Zn_{c}O, where a = b = c.
(9) In an embodiment, the inverter may further include a substrate, wherein the first channel layer, the first source/drain electrode, and the second source/drain electrode may be on the substrate, the first gate insulating layer may be on the first channel layer, and the first gate electrode may be on the first gate insulating layer.
(10) The second gate electrode may be on the substrate, the second gate insulating layer may be on the substrate and cover the second gate electrode, and the second channel layer, the third source/drain electrode, and the fourth source/drain electrode may be on the second gate insulating layer.
(11) An upper surface of the second source/drain electrode may include an exposed upper surface of the second source/drain electrode that is partially exposed between the first gate insulating layer and the second gate insulating layer, and the third source/drain electrode may extend over the exposed upper surface of the second source/drain electrode.
(12) In another example embodiment, the inverter may further include a substrate, wherein the first gate electrode may be on the substrate, the first gate insulating layer may be on the substrate and cover the first gate electrode, and the first channel layer, the first source/drain electrode, and the second source/drain electrode may be on the first gate insulating layer.
(13) The second channel layer, the third source/drain electrode, and the fourth source/drain electrode may be on the substrate, the second gate insulating layer may be on the second channel layer, and the second gate electrode may be on the second gate insulating layer.
(14) An upper surface of the third source/drain electrode may include an exposed upper surface of the third source/drain electrode that is partially exposed between the first gate insulating layer and the second gate insulating layer, and the second source/drain electrode may extend over the exposed upper surface of the third source/drain electrode.
(15) The first gate insulating layer and the second gate insulating layer may constitute a single common gate insulating layer, and the first gate electrode and the second gate electrode may constitute a single common gate electrode.
(16) In an example embodiment, the inverter may further include a substrate, wherein the first channel layer, the first source/drain electrode, and the second source/drain electrode may be on the substrate, the single common gate insulating layer may be on the first channel layer, the single common gate electrode may be buried in the single common gate insulating layer, the second channel layer, the third source/drain electrode, and the fourth source/drain electrode may be on the single common gate insulating layer, and the third source/drain electrode may extend to a surface of the second source/drain electrode along a sidewall of the single common gate insulating layer.
(17) In another embodiment, the inverter may further include a substrate, wherein the second channel layer, the third source/drain electrode, and the fourth source/drain electrode may be on the substrate, the single common gate insulating layer may be on the second channel layer, the single common gate electrode may be buried in the single common gate insulating layer, the first channel layer, the first source/drain electrode, the second source/drain electrode may be on the single common gate insulating layer, and the second source/drain electrode may extend to a surface of the third source/drain electrode along a sidewall of the single common gate insulating layer.
(18) A memory device according to an example embodiment may include a first inverter and a second inverter cyclically connected in series to form a ring oscillator, a first access transistor configured to permit or block access to the first inverter, and a second access transistor configured to permit or block access to the second inverter, wherein the first inverter includes a first pull-up transistor and a first pull-down transistor, the second inverter includes a second pull-up transistor and a second pull-down transistor, the first pull-up transistor and the second pull-up transistor each include a first channel layer including a p-type oxide semiconductor based on tellurium oxide, and the first access transistor, the second access transistor, the first pull-down transistor, and the second pull-down transistor each include a second channel layer including an n-type oxide semiconductor based on indium oxide.
(19) For example, the p-type oxide semiconductor may include TeₐX_{b}O or In_{c}Te_{d}Oₑ, where X may include at least one of selenium (Se), germanium (Ge), or sulfur (S), a ≥ 0.7 and b ≤ 0.3, , c + d = 1, c ≤ 0.5, d ≥ 0.5, and e may be less than a stoichiometric value, and the n-type oxide semiconductor may include indium oxide doped with at least one element selected from gallium (Ga), zinc (Zn), tin (Sn), or tungsten (W).
(20) An electronic apparatus according to an example embodiment may include a main memory, an auxiliary storage, a CPU, and an input/output device, wherein the CPU includes a cache memory, an arithmetic logic unit, and a control unit, the cache memory includes a first inverter and a second inverter cyclically connected in series to form a ring oscillator, a first access transistor configured to permit or block access to the first inverter, and a second access transistor configured to permit or block access to the second inverter, the first inverter includes a first pull-up transistor and a first pull-down transistor, the second inverter includes a second pull-up transistor and a second pull-down transistor, the first pull-up transistor and the second pull-up transistor each include a first channel layer including a p-type oxide semiconductor based on tellurium oxide, and the first access transistor, the second access transistor, the first pull-down transistor, and the second pull-down transistor each include a second channel layer including an n-type oxide semiconductor based on indium oxide.

It should be understood that some example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. An inverter comprising:
a first field-effect transistor comprising a first channel layer, a first source/drain electrode and a second source/drain electrode spaced apart from each other on opposite sides of the first channel layer, a first gate electrode facing the first channel layer, and a first gate insulating layer between the first channel layer and the first gate electrode; and
a second field-effect transistor comprising a second channel layer, a third source/drain electrode and a fourth source/drain electrode spaced apart from each other on opposite sides of the second channel layer, a second gate electrode facing the second channel layer, and a second gate insulating layer between the second channel layer and the second gate electrode,
wherein the second source/drain electrode and the third source/drain electrode are electrically connected to each other,
the first channel layer comprises a p-type oxide semiconductor based on tellurium oxide, and
the second channel layer comprises an n-type oxide semiconductor based on indium oxide.

2. The inverter of claim 1, wherein the p-type oxide semiconductor comprises tellurium oxide doped with at least one element selected from selenium (Se), germanium (Ge), or sulfur (S).

3. The inverter of claim 1, wherein the p-type oxide semiconductor comprises TeₐX_{b}O, where X comprises at least one of selenium (Se), germanium (Ge), or sulfur (S), a ≥ 0.7, and b ≤ 0.3.

4. The inverter of claim 1, wherein the p-type oxide semiconductor comprises InₐTe_{b}O_{c}, where a + b = 1, a ≤ 0.5, and b ≥ 0.5.

5. The inverter of claim 4, wherein c in InₐTe_{b}O_{c} is less than a stoichiometric value.

6. The inverter of claim 5, wherein an oxygen vacancy concentration in InₐTe_{b}O_{c} is 5 % to 80 %.

7. The inverter of any preceding claim, wherein the n-type oxide semiconductor comprises indium oxide doped with at least one element selected from gallium (Ga), zinc (Zn), tin (Sn), or tungsten (W).

8. The inverter of any of claims 1 to 6, wherein the n-type oxide semiconductor comprises InₐGa_{b}Zn_{c}O, where a = b = c.

9. The inverter of any preceding claim, further comprising a substrate, wherein
the first channel layer, the first source/drain electrode, and the second source/drain electrode are on the substrate,
the first gate insulating layer is on the first channel layer, and
the first gate electrode is on the first gate insulating layer, and optionally wherein:
the second gate electrode is on the substrate;
the second gate insulating layer is on the substrate and covers the second gate electrode; and
the second channel layer, the third source/drain electrode, and the fourth source/drain electrode are on the second gate insulating layer, and further optionally wherein:
an upper surface of the second source/drain electrode includes an exposed upper surface of the second source/drain electrode that is partially exposed between the first gate insulating layer and the second gate insulating layer; and
the third source/drain electrode extends over the exposed upper surface of the second source/drain electrode.

10. The inverter of any preceding claim, further comprising a substrate, wherein:
the first gate electrode is on the substrate;
the first gate insulating layer is on the substrate and covers the first gate electrode; and
the first channel layer, the first source/drain electrode, and the second source/drain electrode are on the first gate insulating layer, and optionally wherein:
the second channel layer, the third source/drain electrode, and the fourth source/drain electrode are on the substrate;
the second gate insulating layer is on the second channel layer; and
the second gate electrode is on the second gate insulating layer, and further optionally wherein:
an upper surface of the third source/drain electrode includes an exposed upper surface of the third source/drain electrode that is partially exposed between the first gate insulating layer and the second gate insulating layer; and
the second source/drain electrode extends over the exposed upper surface of the third source/drain electrode.

11. The inverter of any preceding claim, wherein
the first gate insulating layer and the second gate insulating layer constitute a single common gate insulating layer, and
the first gate electrode and the second gate electrode constitute a single common gate electrode.

12. The inverter of claim 11, further comprising a substrate, wherein
the first channel layer, the first source/drain electrode, and the second source/drain electrode are on the substrate,
the single common gate insulating layer is on the first channel layer,
the single common gate electrode is buried in the single common gate insulating layer,
the second channel layer, the third source/drain electrode, the fourth source/drain electrode are on the single common gate insulating layer, and
the third source/drain electrode extends to a surface of the second source/drain electrode along a sidewall of the single common gate insulating layer.

13. The inverter of claim 11, further comprising a substrate, wherein
the second channel layer, the third source/drain electrode, and the fourth source/drain electrode are on the substrate,
the single common gate insulating layer is on the second channel layer,
the single common gate electrode is buried in the single common gate insulating layer,
the first channel layer, the first source/drain electrode, the second source/drain electrode are on the single common gate insulating layer, and
the second source/drain electrode extends to a surface of the third source/drain electrode along a sidewall of the single common gate insulating layer.

14. A memory device comprising:
a first inverter according to any preceding claim and a second inverter according to any preceding claim cyclically connected in series to form a ring oscillator;
a first access transistor configured to permit or block access to the first inverter; and
a second access transistor configured to permit or block access to the second inverter,
wherein the first access transistor and the second access transistor each comprise a second channel layer comprising an n-type oxide semiconductor based on indium oxide.

15. An electronic apparatus comprising:
a main memory;
an auxiliary storage;
a central processing unit (CPU); and
an input/output device,
wherein the CPU comprises a cache memory comprising a memory device according to claim 14, an arithmetic logic unit, and a control unit.
